# FASCICULE DE BREVET EUROPEEN

(11) **EP 0 849 740 B1**
(45) Date de publication et mention de la délivrance du brevet: **20.10.1999**
(21) Numéro de dépôt: 97402807.8
(22) Date de dépôt: 21.11.1997
(51) Int. Cl.: G11C 8/04

(54) **Procédé et dispositif de lecture avec prédiction d'une mémoire**
Leseverfahren und -anordnung mit Speicherprädiktion
Method and reading device with memory prediction

(30) Priorité: 17.12.1996 FR 9615515
(43) Date de publication de la demande: 24.06.1998
(73) Titulaire: STMicroelectronics S.A., 94250 Gentilly (FR)
(72) Inventeur: Gaultier, Jean-Marie, 75116 Paris (FR); Silvestre De Ferron, Gérard, 75116 Paris (FR)
(74) Mandataire: Ballot, Paul Denis Jacques

(56) Documents cités:
- EP-A- 0 315 194
- EP-A- 0 333 231
- US-A- 4 901 227

## Description

L'invention concerne les mémoires des unités de traitement de micro-ordinateurs et, plus particulièrement, un procédé et un dispositif de lecture avec prédiction d'une mémoire de manière à améliorer la sécurité du micro-ordinateur contre les fraudes ainsi que les performances de la mémoire en augmentant la vitesse de sortie des données.

Les données contenues dans une mémoire sont lues à l'aide d'adresses ou codes d'adressage qui sont fournis successivement aux circuits d'adressage ou de sélection de la mémoire par l'unité de traitement du micro-ordinateur ou micro-contrôleur, chaque code d'adressage correspondant à une donnée qui est ensuite traitée par l'unité de traitement selon l'instruction en cours d'exécution. Dans ce mode d'adressage et de lecture de la mémoire, les données contenues dans la mémoire ne sont lues qu'au fur et à mesure de l'arrivée des codes d'adressage, le code d'adressage de la donnée suivante à traiter n'étant fourni qu'après transfert de la donnée précédente dans l'unité de traitement.

Ce mode lecture conduit à un temps mort dans la lecture de la mémoire et donc à une perte de temps, ce qui est préjudiciable à la vitesse de calcul de l'unité de traitement.

Dans la demande de brevet déposée ce jour par la demanderesse, il a été remédié à ce problème dans le cas de l'exécution d'une instruction qui utilise les données contenues à des adresses consécutives de la mémoire. A cet effet, il est prévu, d'une part, d'enregistrer la donnée lue dans un registre dit de donnée pour rendre libre un registre de lecture destiné à mémoriser les signaux lus et, d'autre part, d'incrémenter d'une unité le code d'adressage de manière à lire la mémoire à l'adresse suivante et enregistrer les signaux lus dans le registre de lecture. Cette nouvelle donnée n'est prise en compte par l'unité de traitement que si l'adresse incrémentée est confirmée par l'unité de traitement. Cette nouvelle donnée est donc disponible à un instant qui est antérieur à l'instant d'apparition du nouveau code d'adressage qui serait fourni par l'unité de traitement dans le mode de lecture selon l'art antérieur. Il en résulte un gain de temps d'accès à la mémoire, gain d'autant plus grand que le programme comprend de nombreuses instructions sélectionnant des adresses consécutives de la mémoire.

Dans certaines applications des micro-ordinateurs, pour améliorer la sécurité vis-à-vis des fraudes, par exemple pour éviter que le code d'accès de l'utilisateur puisse être découvert par un fraudeur, il serait souhaitable de compliquer la tâche du fraudeur en faisant en sorte qu'il ne puisse pas découvrir ce code d'accès en analysant les codes d'adressage fournis par l'unité de traitement.

Dans d'autres applications des micro-ordinateurs, par exemple dans les téléphones mobiles, l'utilisateur ou l'abonné a accès à des services divers dont le nombre dépend du prix de son abonnement. A cet effet, le micro-ordinateur est programmé pour tous les services mais l'accès à certains d'entre eux dépendra d'un code d'accès, par exemple un code A pour les services de base correspondant à un certain nombre de programmes, un code B pour les services de base augmentés d'un certain nombre de services particuliers correspondant à d'autres programmes, un code C pour les services de base augmentés d'autres services correspondant à encore d'autres programmes et ainsi de suite.

Dans une telle application, il est important qu'un fraudeur ne puisse pas découvrir les significations des codes A, B et C, ce qui lui permettrait de ne s'abonner qu'aux services de base (code A), les moins chers, et de bénéficier des services additionnels des codes B et C, les plus chers.

Le but de l'invention est donc de mettre en oeuvre un procédé de lecture d'une mémoire associée à une unité de traitement qui ne permette pas à un fraudeur de découvrir les codes d'adressage de la mémoire correspondant à l'exécution d'un programme particulier.

Pour atteindre ce but, l'invention propose que les codes d'adressage successifs de la mémoire se déduisent les uns des autres selon une loi ou fonction de prédiction déterminée et que cette fonction soit vérifiée par les circuits d'adressage de la mémoire. Ainsi, dans le cas où le fraudeur fournirait un code d'adressage ne correspondant pas à la fonction de prédiction prévue, ce code conduirait à lire une donnée erronée et donc à un mauvais fonctionnement ou même à une impossibilité de fonctionnement du système.

La mise en oeuvre de ce procédé conduit à modifier les circuits de lecture de la mémoire. Ainsi, un premier registre d'adresse qui contient le code d'adressage de la mémoire fourni par l'unité de traitement est doublé par un second registre dans lequel est enregistré un code d'adressage qui est calculé par un circuit de calcul à partir du code contenu dans le premier registre d'adresse, ce calcul étant effectué selon une fonction qui a été définie par le programmeur de l'unité de traitement.

Ce code d'adressage calculé ou prédit selon la fonction est utilisé pour lire les cellules correspondantes de la mémoire.

Lorsque le code d'adressage suivant est fourni par l'unité de traitement au premier registre d'adresse, il est comparé au code d'adressage calculé qui est contenu dans le second registre d'adresse.

S'il y a identité, cela signifie que le code d'adressage calculé est conforme à la fonction et que la donnée qui vient d'être lue peut être prise en compte par l'unité de traitement.

S'il n'y a pas identité, le code d'adressage calculé est considéré comme faux et la donnée qui lui correspond n'est pas prise en compte. Le code d'adressage qui est alors utilisé est celui qui vient d'être fourni par l'unité de traitement et c'est la donnée correspondante lue dans la mémoire qui est prise en compte par l'unité de traitement.

Dans ce cas, si le code d'adressage qui est fourni par l'unité de traitement est correct et correspond donc à un déroulement prévu du programme, le système continue à fonctionner normalement. Par contre si le code d'adressage est un code faux introduit par un fraudeur, il aboutit à une mauvaise donnée et donc à un mauvais fonctionnement du système.

Outre la modification des circuits d'adressage, ce nouveau procédé conduit à modifier éventuellement les circuits de lecture qui comprennent alors un premier registre dit de lecture en tous points semblable au registre utilisé dans les mémoires actuelles et un second registre dit de donnée pour mémoriser le contenu du registre de lecture et le rendre disponible pour l'enregistrement des informations lues à l'aide du code d'adressage calculé et contenu dans le second registre d'adresse.

Un tel second registre permet, par ailleurs, de diminuer le temps d'accès à la mémoire par l'unité de traitement lorsque les codes d'adressage successifs suivent la loi de prédiction car la lecture est réalisée avant l'arrivée du code d'adressage fourni par l'unité de traitement.

De manière plus précise, l'invention concerne un procédé de lecture d'une mémoire d'une unité centrale d'un micro-ordinateur à laquelle sont associés des circuits d'adressage des cellules de ladite mémoire comprenant au moins un premier registre d'adresse pour recevoir un code d'adressage de l'unité centrale et des circuits de lecture des signaux lus dans les cellules de la mémoire sélectionnées par lesdits circuits d'adressage comprenant au moins un registre de lecture dans lequel sont enregistrés sous forme binaire les signaux lus, caractérisé en ce qu'il comprend les étapes suivantes :
(a) - Choix d'une fonction de prédiction déterminant un code d'adressage de la mémoire à partir du code d'adressage précédent, et
(b) - Elaboration des programmes d'instructions en tenant compte de la fonction de prédiction choisie à l'étape (a) pour définir les codes d'adressage successifs.

La fonction de prédiction du code d'adressage peut être une fonction non pas du seul code d'adressage qui précède mais de plusieurs codes d'adressage qui précèdent.

Pour la lecture de la mémoire, le procédé est alors le suivant :
(c) - Transfert d'un code d'adressage de l'unité centrale vers le premier registre d'adresse des circuits d'adressage de la mémoire ;
(d) - Comparaison du code d'adressage contenu dans le premier registre d'adresse au code contenu dans un deuxième registre d'adresse ;
(e) - Lecture de la mémoire à l'adresse contenue dans le premier registre d'adresse s'il n'y a pas identité des codes comparés ;
(f) - Lecture de la mémoire à l'adresse contenue dans le deuxième registre d'adresse s'il y a identité des codes comparés ;
(g) - Calcul du code d'adressage suivant à partir du code d'adressage précédent en appliquant la fonction de prédiction définie à l'étape (a) ;
(h) - Enregistrement du code d'adressage calculé par l'étape (g) dans le deuxième registre d'adresse, et
(i) - Retour à l'étape (c).

Pour augmenter la vitesse de lecture de la mémoire 10, une étape intermédiaire (h') est prévue entre les étapes (h) et (i) pour lire la mémoire à l'adresse contenue dans le deuxième registre d'adresse.

En outre, la donnée lue dans la mémoire par l'opération (h') n'est transférée à l'unité centrale de traitement que si la comparaison de l'étape (d) indique l'identité.

Pour mettre en oeuvre le procédé de lecture de la mémoire selon l'invention, les circuits d'adressage et de lecture de la mémoire doivent être modifiés et complétés.

Un tel dispositif est caractérisé en ce que les circuits d'adressage comprennent, en outre :
- un deuxième registre d'adresse ;
- un circuit de calcul connecté entre le premier et le second registre d'adresse pour calculer le code d'adressage suivant à partir du code d'adressage précédent contenu dans le premier registre d'adresse ;
- un circuit comparateur connecté entre le premier et le second registre d'adresse pour comparer les codes d'adressage contenus dans les premier et deuxième registres d'adresse, et
- un circuit de séquencement pour élaborer les signaux séquentiels de commande des registres d'adresse, du circuit de calcul et du circuit comparateur,
- ledit circuit de séquencement comportant un circuit horloge et des circuits logiques pour réaliser les étapes du procédé défini ci-dessus.

Un tel dispositif est également caractérisé en ce que, de plus, les circuits de lecture comprennent, en outre :
- un deuxième registre de lecture dit registre de donnée, et
- un circuit logique de transfert qui connecte les bornes de sortie du premier registre de lecture aux bornes d'entrée du deuxième registre de lecture,
- ledit circuit logique de transfert étant commandé par les signaux fournis par le circuit de séquencement de manière à transférer le contenu du premier registre de lecture dans le deuxième registre de lecture dès que le deuxième registre d'adresse contient le code d'adressage.

L'invention sera donc maintenant décrite en relation avec un exemple particulier de réalisation, ladite description étant faite en relation avec les dessins joints dans lesquels:
- la figure 1 est un schéma d'un dispositif de lecture avec prédiction d'une mémoire selon l'invention, et
- la figure 2 est un diagramme montrant le séquencement de la lecture avec prédiction d'une mémoire selon l'invention.

De manière connue, à une mémoire 10 sont associés des circuits de sélection 12 qui permettent de sélectionner des cellules ou cases de mémoires et des circuits de lecture 14 qui permettent de "recueillir" les signaux lus dans les cellules de mémoire sous forme d'informations binaires ou données. Les adresses des cellules ou cases de mémoire sont fournies aux circuits de sélection 12 par un registre d'adresse dit externe 16A qui les reçoit d'une unité de traitement 18 par l'intermédiaire d'un circuit d'entrées/sorties 20 et d'un bus bidirectionnel 46.

Le registre d'adresse externe 16A et les circuits de sélection 12 constituent les circuits d'adressage 48 de la mémoire.

Ce circuit d'entrées/sorties 20 reçoit par ailleurs les informations ou données lues dans la mémoire 10 par l'intermédiaire des circuits de lecture 14 et d'amplificateurs de sortie 22 et d'un bus unidirectionnel 44. Le circuit entrées/sorties 20 est commandé par un signal OE fourni par l'unité de traitement 18 sur un conducteur 82.

Les circuits de lecture 14 comprennent des amplificateurs de lecture 24 qui amplifient les signaux lus dans les cellules de mémoire sélectionnées et un registre de lecture 26 qui enregistre ou mémorise sous forme binaire les signaux lus.

A la mémoire 10 sont également associés des circuits d'enregistrement qui ne seront pas décrits ici car l'invention ne concerne que la lecture de la mémoire.

Pour mettre en oeuvre le procédé de lecture avec prédiction selon l'invention, les circuits d'adressage 48 et les circuits de lecture 14 doivent être complétés et modifiés.

Ainsi, au registre d'adresse externe 16A doivent être associés :
- un registre d'adresse interne 16B pour enregistrer le code d'adressage qui sera utilisé pour la sélection,
- un circuit de calcul 40 pour calculer le code d'adressage suivant à partir du code d'adressage précédent contenu dans le registre d'adresse externe 16A,
- un circuit comparateur 42 pour comparer les codes d'adressage contenus dans les registres externe 16A et interne 16B, et
- un circuit de séquencement 32 pour élaborer les signaux séquentiels de commande.

Le registre d'adresse interne 16B a ses bornes de sortie qui sont connectées aux circuits de sélection 12 de la mémoire et ses bornes d'entrée qui sont connectées aux bornes de sortie du registre d'adresse externe 16A par l'intermédiaire, d'une part, du circuit de calcul 40 et, d'autre part, du circuit comparateur 42.

Au registre de lecture 26 est associé un registre supplémentaire dit de donnée 28 qui est connecté entre le registre de lecture 26 et les amplificateurs de sortie. Les bornes d'entrée du registre de donnée 28 sont connectées aux bornes de sortie du registre de lecture 26 par l'intermédiaire de circuits électroniques 30 comprenant des portes électroniques de transfert. Les bornes de sortie du registre de donnée 28 sont connectées aux circuits d'entrées/sorties 20 par l'intermédiaire des amplificateurs de sortie 22 et du bus unidirectionnel 44.

Le circuit de séquencement 32 est connecté à l'unité de traitement 18, au circuit de calcul 40, au circuit comparateur 42 et aux circuits électroniques 30. Il comprend des circuits logiques et un circuit horloge pour élaborer les signaux séquentiels de commande du circuit de calcul 40, du comparateur 42, des registres 16A et 16B et des portes électroniques 30.

Le circuit de séquencement 32 reçoit un certain nombre de signaux qui sont répertoriés ALE, ATD et IAE sur des conducteurs 84, 86 et 88, respectivement. Il fournit des signaux de commande au circuit comparateur 42, au circuit de calcul 40 et aux circuits électroniques 30 sur des conducteurs 90, 92 et 94.

Le signal ALE est un signal de validation du code d'adressage, le signal ATD est un signal qui indique que le code d'adressage vient de changer et IAE est un signal qui indique l'identité ou non des contenus des registres 16A et 16B.

Le circuit de calcul 40 réalise la fonction de prédiction de manière à déterminer le code d'adressage suivant à partir du code d'adressage précédent contenu dans le registre d'adresse 16A, cette fonction correspondant à celle qui a été choisie par le programmeur lors de la programmation de l'unité de traitement 18. Cette fonction ou loi de prédiction a pour effet que les données qui sont utilisées pour le traitement ne sont pas enregistrées dans des adresses consécutives de la mémoire mais dans des adresses qui n'ont, vu de l'extérieur, aucun lien logique entre elles, la loi de prédiction n'étant pas connue de l'observateur.

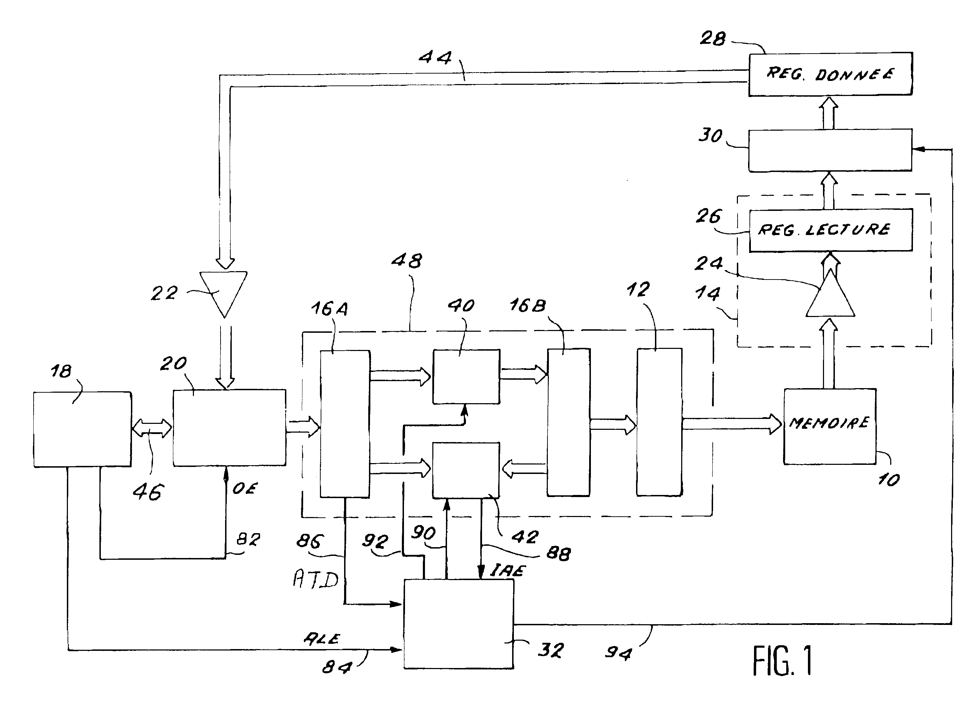

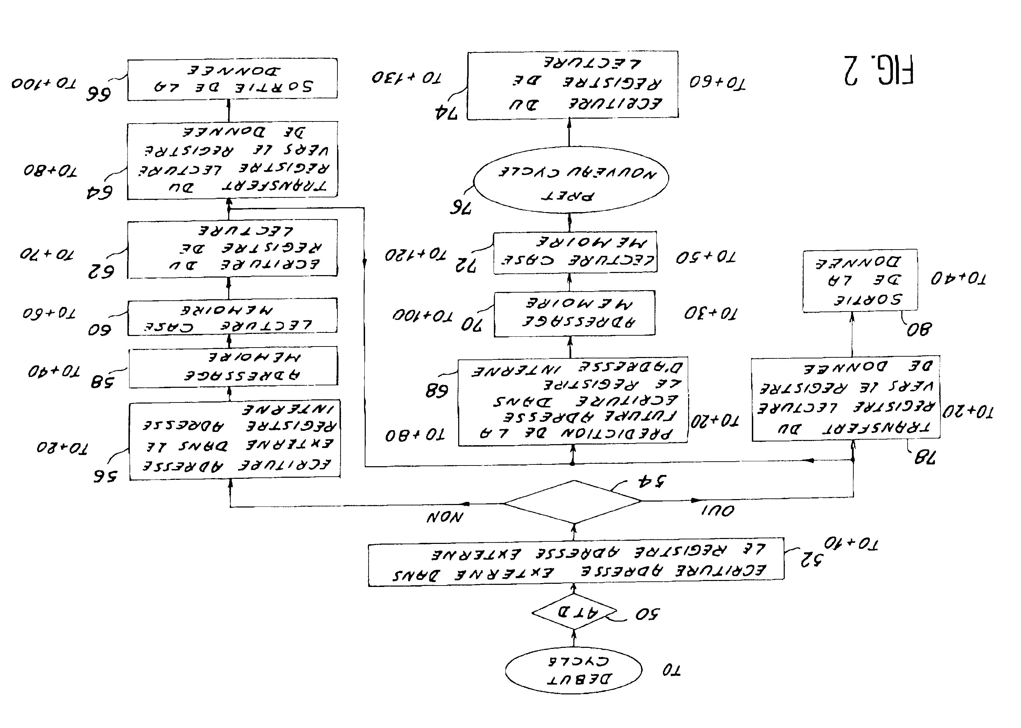

Le séquencement des opérations ou étapes de lecture sera maintenant décrit en relation avec les figures 1 et 2.

A l'instant T0, le signal ATD (losange 50) dit de "Détection de Transition d'Adresse" démarre le cycle de lecture. A l'instant (T0+10ns), le premier code d'adressage en provenance de l'unité de traitement 18 via les circuits d'entrées/sorties 20 est enregistré dans le registre adresse externe 16A (rectangle 52). Ce premier code d'adressage est comparé par le circuit comparateur 42 au code contenu dans le registre adresse interne 16B (losange 54).

S'agissant du départ du cycle, le code contenu dans le registre 16B ne comprend, par exemple, que des chiffres "0" de sorte que la comparaison indique l'absence d'identité. Cette absence d'identité conduit le circuit de séquencement à fournir au temps (T0+20ns) un signal d'enregistrement du premier code d'adressage dans le registre adresse interne 16B (rectangle 56). Au temps (T0+40ns), le premier code d'adressage sélectionne la mémoire 10 (rectangle 58). Au temps (T0+60ns), la lecture de la mémoire est réalisée (rectangle 60). Au temps (T0+70ns), les signaux lus dans la mémoire sont enregistrés sous forme binaire dans le registre de lecture 26 (rectangle 62). Au temps (T0+80ns), le transfert du contenu du registre de lecture 26 vers le registre de donnée est effectué via les portes électroniques de transfert 30 (rectangle 64). Au temps (T0+100ns), la donnée contenue dans le registre de donnée 28 est transférée à l'unité de traitement 18 via le circuit entrées/sorties 20 (rectangle 66) sous la commande d'un signal OE (figure 1).

Dès que la donnée est enregistrée dans le registre de lecture 26 au temps (T0+70ns), le contenu du registre interne 16B peut être modifié pour enregistrer au temps (T0+80ns) le deuxième code d'adressage calculé par le circuit de calcul 40 (rectangle 68). Au temps (T0+100ns), le deuxième code d'adressage sélectionne les cellules de mémoire correspondantes (rectangle 70). Au temps (T0+120ns), les cellules de mémoire sélectionnées sont lues (rectangle 72) et les signaux lus sont enregistrés sous forme binaire dans le registre de lecture au temps (T0+130ns) (rectangle 74).

Dès que cet enregistrement est effectué la mémoire est prête pour un nouveau cycle (ellipse 76), qui commence par l'enregistrement dans le registre adresse externe 16A du deuxième code d'adressage en provenance de l'unité de traitement 18 via le circuit entrées/sorties 20 (losange 50 et rectangle 52). Ce deuxième code d'adressage, qui est fourni par l'unité de traitement, est comparé au deuxième code d'adressage tel que calculé (rectangle 68) par le circuit de calcul 40.

S'il n'y a pas identité, les étapes sont celles décrites ci-dessus.

S'il y a identité, ce qui est alors le cas le plus probable, le transfert du contenu du registre de lecture 26 au registre de donnée 28 est effectué au temps (T0+20ns) (rectangle 78) du second cycle en cours, ce contenu correspondant à celui enregistré au temps (T0+130ns) (rectangle 74) du premier cycle, c'est-à-dire le cycle précédent. Le transfert de la donnée vers l'unité de traitement est effectué au temps (T0+40ns) via le circuit entrées/sorties 20 (rectangle 80) sous la commande du signal OE (figure 1).

De manière simultanée, les opérations définies par les rectangles 68,70,72 et 74 sont réalisées à partir du deuxième code d'adressage fourni par l'unité de traitement 18, ce qui permet d'enregistrer au temps (T0+60ns) de ce second cycle le contenu des cellules de mémoire sélectionnées par un troisième code d'adressage tel que calculé par le circuit de calcul 40.

Sur la figure 2, la comparaison des temps successifs montrent qu'il faut une durée de 100ns pour sortir une donnée de la mémoire 10 dans le cas d'un mode de lecture selon l'art antérieur. Cette durée est réduite à 40ns dans le mode de lecture selon l'invention dans le cas où les adresses consécutives résultent de l'application de la fonction de prédiction.

Le fonctionnement qui vient d'être décrit montre que si un fraudeur introduit un code d'adressage qui n'obéit pas à la fonction de prédiction, ce code incorrect conduira à sortir une donnée fausse par les opérations 56 à 66. En outre, les codes d'adressage qui seront calculés dans cette hypothèse par les opérations 68 à 74 ne correspondront pas aux codes d'adressage qui seraient fournis par le fraudeur pour la suite des opérations de sorte que les codes du fraudeur ne pourraient être traités que suivant les opérations 56 à 66, ce qui aboutira à sortir des données fausses.

Comme la fonction de prédiction n'est contenue que dans les circuits d'adressage de la mémoire, le fraudeur ne pourra pas la déterminer en testant la mémoire de manière systématique.

La description ci-dessus du procédé et du dispositif permet de définir un procédé de lecture de la mémoire (10) qui comprend d'abord les étapes suivantes :
(a) - Choix d'une fonction de prédiction déterminant un code d'adressage de la mémoire à partir du code d'adressage précédent, et
(b) - Elaboration des programmes d'instructions en tenant compte de la fonction de prédiction choisie à l'étape (a) pour définir les codes d'adressage successifs.

Pour la lecture de la mémoire 10, ces deux premières étapes (a) et (b) conduisent aux étapes suivantes :
(k) - Application d'un code d'adressage aux circuits d'adressage de la mémoire par l'unité centrale ;
(m) - Lecture de la mémoire à l'adresse définie par le code d'adressage de l'étape (k) ;
(n) - Enregistrement des signaux lus dans un premier registre dit de lecture puis dans un deuxième registre dit de donnée ;
(o) - Calcul du code d'adressage suivant à partir du code d'adressage précédent en appliquant la fonction de prédiction définie par l'étape (a) ;
(p) Lecture de la mémoire à l'adresse calculée par l'étape (o) et transfert du contenu du registre de donnée vers l'unité centrale ;
(q) - Application du code d'adressage suivant aux circuits d'adressage de la mémoire par l'unité centrale ;
(r) - Comparaison du code d'adressage calculé au code d'adressage fourni par l'unité centrale :
   . s'il y a identité des codes comparés : transfert du contenu du registre de donnée vers l'unité centrale, puis retour à l'étape (o) ;
   . s'il n'y a pas identité des codes comparés : retour à l'étape (m).

Un tel procédé de lecture de la mémoire 10 selon les opérations (k) à (r) conduit à utiliser deux registres 26 et 28 lors de la lecture mais apporte un gain de temps et donc une vitesse de lecture plus élevée en moyenne.

Si l'aspect gain en vitesse n'est pas primordial, le procédé de lecture peut être simplifié et comprend alors les étapes suivantes :
(c) - Transfert d'un code d'adressage de l'unité centrale 18 vers le premier registre d'adresse 16A des circuits d'adressage 48 de la mémoire 10;
(d) - Comparaison du code d'adressage contenu dans le premier registre d'adresse 16A au code contenu dans un deuxième registre d'adresse 16B;
(e) - Lecture de la mémoire 10 à l'adresse contenue dans le premier registre d'adresse 16A s'il n'y a pas identité des codes comparés ;
(f) - Lecture de la mémoire 10 à l'adresse contenue dans le deuxième registre d'adresse 16B s'il y a identité des codes comparés ;
(g) - Calcul du code d'adressage suivant à partir du code d'adressage précédent en appliquant la fonction de prédiction définie à l'étape (a) ;
(h) - Enregistrement du code d'adressage calculé par l'étape (g) dans le deuxième registre d'adresse 16B, et
(i) - Retour à l'étape (c).

Dans ce deuxième mode de lecture simplifié, un seul registre en lecture est nécessaire à la sortie de la mémoire (10).

Dans le cas où il est prévu un registre de lecture 26 et un registre de donnée 28, l'opération (o) de calcul du code d'adressage peut commencer dès l'enregistrement des signaux lus dans le registre de lecture 26 à condition que le code d'adressage résultant du calcul ne soit enregistré dans le registre d'adresse 16B qu'après le transfert de la donnée lue du registre de lecture au registre d'adresse. Dans ce cas, le début de l'opération (o) s'intercale dans l'opération (n) dès l'enregistrement des signaux lus dans le registre de lecture 26.

L'invention a été décrite en relation avec une fonction de prédiction relativement simple dans laquelle le code d'adressage suivant est calculé à partir du code d'adressage précédent. Il est clair que cette fonction de prédiction peut être plus compliquée en faisant en sorte que le code d'adressage calculé dépende de plusieurs paramètres et notamment des valeurs de plusieurs codes d'adressage qui précèdent.

## Revendications

1. Procédé de lecture d'une mémoire (10) d'une unité centrale de traitement (18) d'un micro-ordinateur à laquelle sont associés des circuits d'adressage (48) des cellules de ladite mémoire comprenant au moins un premier registre d'adresse (16A) pour recevoir un code d'adressage de l'unité centrale (18) et des circuits de lecture (14) des signaux lus dans les cellules de la mémoire (10) sélectionnées par lesdits circuits d'adressage (48) comprenant au moins un registre de lecture (26) dans lequel sont enregistrés sous forme binaire les signaux lus, caractérisé en ce qu'il comprend les étapes suivantes :
(a) - Choix d'une fonction de prédiction déterminant un code d'adressage de la mémoire (10) à partir d'au moins un code d'adressage précédent, et
(b) - Elaboration des programmes d'instructions en tenant compte de la fonction de prédiction choisie à l'étape (a) pour définir les codes d'adressage successifs.

2. Procédé selon la revendication 1, caractérisé en ce qu'il comprend, en outre, les étapes suivantes :
(c) - Transfert d'un code d'adressage de l'unité centrale (18) vers le premier registre d'adresse (16A) des circuits d'adressage (48) de la mémoire (10) ;
(d) - Comparaison du code d'adressage contenu dans le premier registre d'adresse (16A) au code contenu dans un deuxième registre d'adresse (16B) ;
(e) - Lecture de la mémoire (10) à l'adresse contenue dans le premier registre d'adresse (16A) s'il n'y a pas identité des codes comparés ;
(f) - Lecture de la mémoire (10) à l'adresse contenue dans le deuxième registre d'adresse (16B) s'il y a identité des codes comparés ;
(g) - Calcul du code d'adressage suivant à partir du code d'adressage précédent en appliquant la fonction de prédiction définie à l'étape (a) ;
(h) - Enregistrement du code d'adressage calculé par l'étape (g) dans le deuxième registre d'adresse (16B), et
(i) - Retour à l'étape (c).

3. Procédé selon la revendication 2, caractérisé en ce qu'il comprend, entre les étapes (h) et (i), une étape intermédiaire (h') de lecture de la mémoire (10) à l'adresse contenue dans le deuxième registre d'adresse (16B).

4. Procédé selon la revendication 3, caractérisé en ce que la donnée lue dans la mémoire (10) par l'opération (h') n'est transférée à l'unité de traitement (18) que si la comparaison de l'étape (d) indique l'identité.

5. Procédé selon la revendication 1, caractérisé en ce qu'il comprend, en outre, les étapes suivantes :
(k) - Application d'un code d'adressage aux circuits d'adressage (48) de la mémoire (10) par l'unité centrale (18) ;
(m) - Lecture de la mémoire (10) à l'adresse définie par le code d'adressage de l'étape (k) ;
(n) - Enregistrement des signaux lus dans un premier registre dit de lecture (26) puis dans un deuxième registre dit de donnée (28) ;
(o) - Calcul du code d'adressage suivant à partir du code d'adressage précédent en appliquant la fonction de prédiction définie par l'étape (a) ;
(p) Lecture de la mémoire (10) à l'adresse calculée par l'étape (o) et transfert du contenu du registre de donnée (28) vers l'unité centrale (18) ;
(q) - Application du code d'adressage suivant aux circuits d'adressage (12) de la mémoire (10) par l'unité centrale (18) ;
(r) - Comparaison du code d'adressage calculé au code d'adressage fourni par l'unité centrale (18) :
. s'il y a identité des codes comparés : transfert du contenu du registre de donnée (28) vers l'unité centrale (18), puis retour à l'étape (o) ;
. s'il n'y a pas identité des codes comparés : retour à l'étape (m).

6. Procédé selon la revendication 5, caractérisé en ce que l'étape (e) est intercalée dans l'étape (n) dès l'enregistrement des signaux lus dans le registre de lecture (26).

7. Dispositif de lecture d'une mémoire (10) d'une unité centrale de traitement (18) d'un micro-ordinateur à laquelle sont associés des circuits d'adressage (48) des cellules de ladite mémoire (10) comprenant un premier registre d'adresse (16A) pour recevoir un code d'adressage de l'unité centrale (18) et des circuits de lecture (14) des signaux lus dans les cellules de la mémoire (10) sélectionnées par lesdits circuits d'adressage (48) comprenant un premier registre de lecture (26) dans lequel sont enregistrés sous forme binaire les signaux lus, caractérisé en ce que les circuits d'adressage comprennent, en outre :
- un deuxième registre d'adresse (16B) ;
- un circuit de calcul (40) connecté entre le premier (16A) et le second registre d'adresse (16B) pour calculer le code d'adressage suivant à partir du code d'adressage précédent contenu dans le premier registre d'adresse (16A) ;
- un circuit comparateur (42) connecté entre le premier (16A) et le second registre d'adresse (16B) pour comparer les codes d'adressage contenus dans les premier et deuxième registres d'adresse (16A, 16B), et
- un circuit de séquencement (32) pour élaborer les signaux séquentiels de commande des registres d'adresse (16A, 16B), du circuit de calcul (40) et du circuit comparateur (42),
- ledit circuit de séquencement (32) comportant un circuit horloge et des circuits logiques pour réaliser les étapes définies par les revendications précédentes 2 à 5.

8. Dispositif selon la revendication 7, caractérisé en ce que les circuits de lecture comprennent, en outre :
- un deuxième registre de lecture (28), et
- un circuit logique de transfert (30) qui connecte les bornes de sortie du premier registre de lecture (26) aux bornes d'entrée du deuxième registre de lecture (28),
- ledit circuit logique de transfert (30) étant commandé par les signaux fournis par le circuit de séquencement (32) de manière à transférer le contenu du premier registre de lecture (26) dans le deuxième registre de lecture dès que le deuxième registre d'adresse (16A) contient le code d'adressage.

## Patentansprüche

1. Verfahren zum Lesen eines Speichers (10) einer zentralen Verarbeitungseinheit (18) eines Mikrorechners, dem Adressierschaltungen (48) für Zellen dieses Speichers zugeordnet sind, mit wenigstens einem ersten Adreßregister (16A) zum Empfangen eines Adreßcodes von der zentralen Verarbeitungseinheit (18) und Schaltungen zum Lesen (14) von Signalen, die aus den Speicherzellen (10) gelesen werden, welche von den Adressierschaltungen (48) ausgewählt wurden, die wenigstens ein Leseregister (26) umfassen, in dem in binärer Form die gelesenen Signale gespeichert werden, gekennzeichnet durch die folgenden Verfahrensschritte:
(a) Auswählen einer Prädiktionsfunktion, welche einen Adreßcode des Speichers (10) ausgehend von wenigstens einem vorhergehenden Adreßcode bestimmt,
(b) Ausarbeiten von Befehlsprogrammen unter Berücksichtigung der im Schritt (a) gewählten Prädiktionsfunktion, um die nachfolgenden Adreßcodes zu definieren.

2. Verfahren nach Anspruch 1, gekennzeichnet durch die folgenden weiteren Verfahrensschritte:
(c) Übertragen eines Adreßcodes der zentralen Verarbeitungseinheit (18) zu dem ersten Adreßregisters (16A) der Adressierschaltungen (48) des Speichers (10);
(d) Vergleichen des in dem ersten Adreßregister (16A) enthaltenen Adreßcodes mit dem in dem zweiten Adreßregister (16B) enthaltenen Codes;
(e) Lesen des Speichers (10) bei der Adresse, die in dem ersten Adreßregister (16A) enthalten ist, wenn die verglichenen Codes nicht übereinstimmen;
(f) Lesen des Speichers (10) bei der Adresse, die in dem zweiten Adreßregister (16B) enthalten ist, wenn die verglichen Codes übereinstimmen,;
(g) Berechnen des folgenden Adreßcodes ausgehend von dem vorhergehenden Adreßcode unter Anwendung der im Schritt (a) definierten Prädiktionsfunktion;
(h) Speichern des im Schritt (g) berechneten Adreßcodes in dem zweiten Adreßregister (16B), und
(i) Zurückkehren zum Schritt (c)

3. Verfahren nach Anspruch 2, dadurch gekennzeichnet, daß zwischen den Schritten (h) und (i) ein Zwischenschritt (h') zum Lesen des Speichers (10) bei der Adresse, die in dem zweiten Adreßregister (16B) enthalten ist, eingefügt wird.

4. Verfahren nach Anspruch 3, dadurch gekennzeichnet, daß die mit der Operation (h') in dem Speicher (10) gelesen Daten nur zu Verarbeitungseinheit (18) übertragen werden, wenn der Vergleich im Schritt (d) die Identität ergab.

5. Verfahren nach Anspruch 1, gekennzeichnet durch die folgenden weiteren Verfahrensschritte:
(k) Anlegen eines Adreßcodes an die Adressierschaltungen (48) des Speichers (10) durch die zentrale Verarbeitungseinheit (18)
(m) Lesen des Speichers (10) bei der im Schritt (k) durch den Adreßcode definierten Adresse;
(n) Speichern von gelesenen Signalen in einem ersten Register, das Leseregister (26) genannt wird, und dann in einem zweiten Register, das Datenregister (28) genannt wird;
(o) Berechnen des folgenden Adreßcodes ausgehend von dem vorhergehenden Adreßcode unter Anwendung der im Schritt (a) definierten Prädiktionsfunktion;
(p) Lesen des Speichers (10) bei der im Schritt (o) berechneten Adresse und Übertragen des Inhalts des Datenregisters (28) zur zentralen Verarbeitungseinheit (18);
(q) Anlegen des folgenden Adreßcodes an die Adressierschaltungen (12) des Speichers (10) durch die zentrale Verarbeitungseinheit (18);
(r) Vergleichen des berechneten Adreßcodes mit dem von der zentralen Verarbeitungseinheit (18) gelieferten Adreßcode:
wenn die verglichenen Codes übereinstimmen, Übertragen des Inhalts des Datenregisters (28) zur zentralen Verarbeitungseinheit (18) und dann Zurückkehren zum Schritt (o);
wenn die verglichenen Codes nicht übereinstimmen, Zurückkehren zum Schritt (m).

6. Verfahren nach Anspruch 5, dadurch gekennzeichnet, daß der Schritt (e) in den Schritt (n) zum Speichern der gelesenen Signale in dem Leseregister (26) eingefügt wird.

7. Vorrichtung zum Lesen eines Speichers (10) einer zentralen Verarbeitungseinheit (18) eines Mikrorechners, dem Adressierschaltungen (48) für Zellen dieses Speichers zugeordnet sind, mit wenigstens einem ersten Adreßregister (16A) zum Empfangen eines Adreßcodes von der zentralen Verarbeitungseinheit (18) und Schaltungen zum Lesen (14) von Signalen, die aus den Speicherzellen (10) gelesen werden, welche von den Adressierschaltungen (48) ausgewählt wurden, die wenigstens ein erstes Leseregister (26) umfassen, in dem die gelesenen Signale in binärer Form gespeichert sind, dadurch gekennzeichnet, daß die Adressierschaltungen folgende Merkmale aufweisen:
ein zweites Adreßregister (16B)
eine Rechenschaltung (40), die zwischen dem ersten (16A) und dem zweiten Adreßregister (16B) angeschlossen ist, um den folgenden Adreßcodes ausgehend von dem vorhergehenden Adreßcode, der in dem ersten Adreßregister (16A) enthalten ist, zu berechnen;
eine Vergleicherschaltung (42), die zwischen den ersten (16A) und dem zweiten Adreßregister (16B) angeschlossen ist, um die in dem ersten und in dem zweiten Adreßregister (16A, 16B) enthaltenen Adreßcodes zu vergleichen, und
eine Folgesteuerschaltung (32) zum Entwickeln sequentieller Signale zum Steuern der Adreßregister (16A, 16B), der Rechenschaltung (40) und der Vergleicherschaltung (42),
wobei die Folgesteuerschaltung (32) eine Taktschaltung und Logikschaltungen umfaßt, um die in den vorangehenden Ansprüchen 2 bis 5 definierten Schritte zu realisieren.

8. Vorrichtung nach Anspruch 7, dadurch gekennzeichnet, daß die Leseschaltungen folgenden Merkmale aufweisen:
ein zweites Leseregister (28) und
eine Übertragungslogikschaltung (30) welche die Ausgangsanschlüsse des ersten Leseregisters (26) mit den Eingangsanschlüssen des zweiten Leseregisters (28) verbindet, wobei die Übertragungslogikschaltung (30) von Signalen gesteuert wird, welche von der Folgesteuerschaltung (32) geliefert werden, um den Inhalt des ersten Leseregisters (26) in das zweite Leseregister zu übertragen, wenn das zweite Adreßregister (16A) den Adreßcode enthält.

## Claims

1. A method of reading a memory (10) of a central processing unit (18) of a micro-computer to which circuits (48) are connected for addressing cells of said memory having at least a first address register (16A) for receiving an address code from the central unit (18) and circuits (14) for reading signals read in the cells of the memory (10) selected by said address circuits (48) having at least one read register (26) in which the signals read are stored in binary form, characterised in that it consists of the following steps:
(a) - a prediction function determining an address code of the memory (10) is selected on the basis of at least one preceding address code and
(b) - instruction programmes are worked out taking account of the prediction function selected in step (a) in order to define the successive address codes.

2. A method as claimed in claim 1, characterised in that it also incorporates the following steps:
(c) - an address code is transferred from the central unit (18) to the first address register (16A) of the addressing circuits (48) of the memory (10);
(d) - the address code contained in the first address register (16A) is compared with the code contained in a second address register (16B);
(e) - the memory (10) is read at the address contained in the first address register (16A) if the compared codes are not identical;
(f) - the memory (10) is read at the address contained in the second address register (16B) if the compared codes are identical;
(g) - the next address code is calculated on the basis of the preceding address code by applying the prediction function defined in step (a);
(h) - the address code calculated by step (g) is stored in the second address register (16B); and
(i) - return to step (c).

3. A method as claimed in claim 2, characterised in that it incorporates between steps (h) and (i) an intermediate step (h') whereby the memory (10) is read at the address contained in the second address register (16B).

4. A method as claimed in claim 3, characterised in that the data read in the memory (10) during operation (h') is not transferred to the processing unit (18) unless the comparison in stage (d) produces an identical match.

5. A method as claimed in claim 1, characterised in that it also incorporates the following steps:
(k) - an address code is applied to the address circuits (48) of the memory (10) by the central unit (18);
(m) - the memory (10) is read at the address defined by the address code of step (k);
(n) - the signals read are stored in a first register referred to as the read register (26) and then in a second register which is a data register (28);
(o) - the next address code is calculated on the basis of the preceding address code by applying the prediction function defined by step (a);
(p) - the memory (10) is read at the address calculated by step (o) and the contents of the data register (28) are transferred to the central processing unit (18);
(q) - the next address code is applied to the address circuits (12) of the memory (10) by the central unit (18);
(r) - the calculated address code is compared with the address code supplied by the central unit (18):
. if the codes compared are an identical match: the contents of the data register (28) are transferred to the central unit (18), then return to step (o);
. if the codes compared are not an identical match: return to step (m).

6. A method as claimed in claim 5, characterised in that step (e) is inserted in step (n) as soon as the signals read have been stored in the read register (26).

7. A device for reading a memory (10) of a central processing unit (18) of a micro-computer connected to circuits (48) for addressing the cells of said memory (10) having a first address register (16A) for receiving an address code from the central unit (18) and circuits (14) for reading the signals read in the cells of the memory (10) selected by said address circuits (48) having a first read register (26) in which the signals read are stored in binary form, characterised in that the address circuits also have:
- a second address register (16B);
- a calculating circuit (40) connected between the first (16A) and the second address register (16B) for calculating the next address code on the basis of the preceding address code contained in the first address register (16A);
- a comparator circuit (42) connected between the first (16A) and the second address register (16B) for comparing the address codes contained in the first and second address registers (16A, 16B) and
- a sequencing circuit (32) for working out the sequential control signals for the address registers (16A, 16B), the calculating circuit (40) and the comparator circuit (42),
- said sequencing circuit (32) having a clock circuit and logic circuits in order to run the steps defined in the preceding claims 2 to 5.

8. A device as claimed in claim 7, characterised in that the read circuits also have:
- a second read register (28) and
- a transfer logic circuit (30) which connects the output terminals of the first read register (26) to the input terminals of the second read register (28),
- said transfer logic circuit (30) being controlled by the signals supplied by the sequencing circuit (32) so as to transfer the contents of the first read register (26) into the second read register as soon as the second address register (16A) contains the address code.
